# DEMANDE DE BREVET EUROPEEN

(11) **EP 2 690 434 A1**
(43) Date de publication de la demande: **29.01.2014**
(21) Numéro de dépôt: 13177536.3
(22) Date de dépôt: 23.07.2013
(51) Int. Cl.: G01N 30/54, G01N 30/60, H01L 37/00, F25B 21/02, H01L 23/38, H01L 35/00

(54) **Micro-dispositif d'analyse par chromatographie en phase gazeuse compact comprenant au moins un module thermoélectrique**

(30) Priorité: 26.07.2012 FR 1257260
(71) Demandeur: Commissariat à l'Énergie Atomique et aux Énergies Alternatives, 75015 Paris (FR)
(72) Inventeur: Blanc, Henri, 38000 GRENOBLE (FR); Arcamone, Julien, 38950 ST MARTIN LE VINOUX (FR)
(74) Mandataire: Ahner, Philippe

(57) **Abrégé**

Dispositif d'analyse par chromatographie en phase gazeuse comportant :
- une micro-colonne de chromatographie (2),
- un module de détection (4) comportant au moins un détecteur de type NEMS et/ou MEMS disposé dans un canal,
- une connexion fluidique directe entre une extrémité d'évacuation de la micro-colonne de chromatographie (2) et une extrémité d'admission du canal du module de détection (4),
- un module thermoélectrique (6) dont la face chaude forme des moyens de chauffage de la micro-colonne de chromatographie (2) et la face froide forme les moyens pour refroidir le module de détection (4).

## Description

### DOMAINE TECHNIQUE ET ART ANTÉRIEUR

La présente invention se rapporte à un micro-dispositif d'analyse par chromatographie en phase gazeuse offrant une grande compacité

Un micro-dispositif d'analyse par chromatographie en phase gazeuse comporte un injecteur, une ou plusieurs micro-colonnes , et un ou plusieurs détecteurs à base de NEMS (systèmes nanoélectromécaniques) et MEMS (systèmes microélectromécaniques) connectés en série avec la ou les micro-colonnes et une électronique de traitement du ou des signaux électriques émis par les détecteurs. Un tel micro-dispositif est par exemple utilisé pour l'analyse et la détection de gaz.

Afin d'assurer une bonne séparation des espèces dans la micro-colonne et une détection plus sélective sur les détecteurs, une fonctionnalisation chimique est effectuée sur les parois internes des colonnes et sur les éléments sensibles des détecteurs.

Pour que la colonne remplisse au mieux sa fonction de décalage spatial des espèces, il est préférable de la chauffer au dessus de la température ambiante, à une température variant en fonction des produits à analyser, généralement entre 50°C et 200 °C. D'autre part, dans certains cas, il peut être intéressant de refroidir au dessous de la température ambiante le ou les détecteurs, afin d'améliorer l'effet de piégeage des composés gazeux par physisorption : par exemple entre + 10°C, et - 20°C.

Le document WO 2011/133721 décrit un micro-dispositif d'analyse par chromatographie comportant des moyens de chauffage et/ou de refroidissement de la micro-colonne formés par un module thermoélectrique et des moyens de chauffage des détecteurs.

### EXPOSÉ DE L'INVENTION

C'est un but de la présente invention d'offrir un dispositif d'analyse par chromatographie en phase gazeuse offrant une grande compacité et un nombre de composants réduit.

Le but précédemment énoncé est atteint par un dispositif d'analyse par chromatographie en phase gazeuse comportant au moins une micro-colonne, au moins un détecteur disposé dans un canal connecté en série avec la micro-colonne, des moyens de chauffage de la micro-colonne et des moyens de refroidissement du au moins un détecteur, les moyens de chauffage et les moyens de refroidissement étant formés par au moins un module thermoélectrique dont la face chaude forme les moyens de chauffage et dont la face froide forme les moyens de refroidissement.

Ce dispositif présente une grande compacité puisque le même élément assure à la fois le chauffage et le refroidissement.

Dans un mode de réalisation, le dispositif comporte plusieurs micro-colonnes connectées chacune à un module de détection. Les micro-colonnes peuvent être toutes en contact avec la face chaude du module thermoélectrique, ou les micro-colonnes sont superposées, une seule étant alors en contact avec la face chaude.

Les modules de détection peuvent également être tous en contact avec la face froide du module thermoélectrique, ou alors être superposée, un seul module étant alors en contact avec la face froide.

Les matériaux des colonnes et/ou des modules de détections sont bons conducteurs thermiques, l'ensemble de l'empilement est donc sensiblement à la même température.

Dans un autre mode de réalisation, le dispositif d'analyse comporte plusieurs modules thermoélectriques.

La présente invention a alors pour objet un dispositif d'analyse par chromatographie en phase gazeuse comportant :
- au moins une micro-colonne de chromatographie,
- au moins un module de détection comportant au moins un détecteur de type NEMS et/ou MEMS disposé dans un canal,
- une connexion fluidique directe entre une extrémité d'évacuation de la micro-colonne de chromatographie et une extrémité d'admission du canal du module de détection,
   ladite micro-colonne de chromatographie et ledit détecteur formant un sous-ensemble d'analyse,
- des moyens de chauffage de la micro-colonne de chromatographie formés par une face chaude d'au moins un module thermoélectrique,
- des moyens pour refroidir le module de détection,
les moyens pour refroidir le module de détection étant formés par la face froide du module thermoélectrique.

Dans un mode de réalisation, le dispositif comporte au moins un premier et un deuxième module thermoélectrique. Dans un exemple, une face chaude du premier module thermoélectrique forme les moyens de chauffage, une face froide du premier module thermoélectrique est en contact avec une face chaude du deuxième module thermoélectrique et une face froide du deuxième module thermoélectrique forme les moyens de refroidissement.

Dans un autre exemple une face chaude du premier module thermoélectrique forme les moyens de chauffage, une face froide du premier module est en contact avec un dissipateur thermique, une face chaude du deuxième module thermoélectrique est en contact avec ledit dissipateur thermique et une face froide du deuxième module thermoélectrique forme les moyens de refroidissement.

Selon une caractéristique additionnelle, le dispositif comportant au moins deux sous-ensembles d'analyse connectés en série.

Les micro-colonnes de chromatographie peuvent alors être superposées de sorte qu'une seule des micro-colonnes de chromatographie soit en contact avec les moyens de chauffage.

Les modules de détection peuvent être superposés de sorte qu'un seul module de détection soit en contact avec les moyens de refroidissement.

Dans un autre exemple, les micro-colonnes de chromatographie étant juxtaposées de sorte que toutes les micro-colonnes de chromatographie soient en contact avec les moyens de chauffage.

Dans un autre exemple, les modules de détection sont juxtaposés de sorte que tous les modules de détection soient en contact avec les moyens de refroidissement.

Le dispositif comporte avantageusement des moyens d'isolation thermique au moins autour du module ou de l'ensemble des modules.

La au moins une connexion fluidique est de préférence formée par un capillaire.

Le dispositif d'analyse peut avantageusement comporter au moins un capteur de température et/ou un capteur d'hygrométrie et/ou un capteur de débit.

Chaque sous-ensemble est de préférence fonctionnalisé pour détecter un ou plusieurs analytes donnés.

### BRÈVE DESCRIPTION DES DESSINS

La présente invention sera mieux comprise à l'aide de la description qui va suivre et des dessins en annexes sur lesquels:
- la figure 1 est une représentation schématique d'un exemple d'un premier mode de réalisation d'un dispositif d'analyse selon l'invention,
- la figure 2 est une représentation schématique d'un autre exemple du premier mode de réalisation d'un dispositif d'analyse selon l'invention,
- la figure 3 est une représentation schématique d'un autre exemple du premier mode de réalisation d'un dispositif d'analyse selon l'invention,
- la figure 4 est une représentation schématique d'un exemple d'un deuxième mode de réalisation d'un dispositif d'analyse selon l'invention comportant deux éléments thermoélectriques,
- la figure 5 est une représentation schématique d'un autre exemple d'un deuxième mode de réalisation d'un dispositif d'analyse selon l'invention comportant deux éléments thermoélectriques,
- la figure 6 est une vue en arrachée d'un exemple d'un élément thermoélectrique.

### EXPOSÉ DÉTAILLÉ DE MODES DE RÉALISATION PARTICULIERS

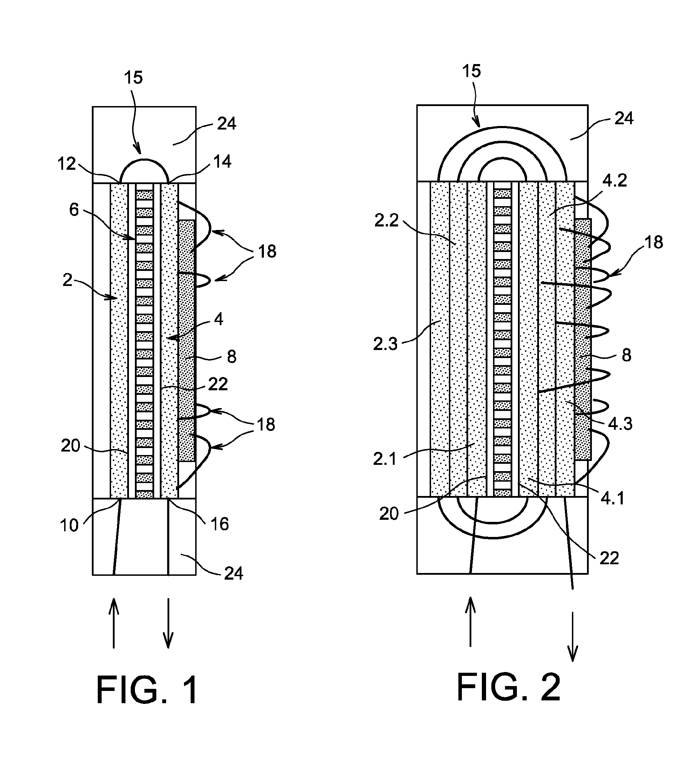

Sur la figure 1, on peut voir une représentation schématique d'un exemple d'un premier mode de réalisation d'un dispositif d'analyse selon l'invention comportant une colonne de chromatographie 2, un module de détection 4 et des moyens de chauffage et de refroidissement 6.

Dans la description qui va suivre, une colonne de chromatographie est une micro-colonne de chromatographie réalisée dans un substrat par des technologies de la microélectronique. Un module de détection comporte un ou plusieurs détecteurs de type NEMS (Système Nano-électromécanique) et MEMS (système micro-électromécanique) disposés dans un canal, les détecteurs étant destinés à être mis en contact avec les analytes séparés par la micro-colonne de chromatographie. Les détecteurs NEMS et MEMS sont, eux aussi, réalisés sur un substrat par des technologies de la microélectronique.

Par ailleurs, les termes "analyte", "élément", "espèce" et "composé" sont considérés comme synonymes et désignent les composés gazeux contenus dans le gaz à analyser.

Le dispositif comporte également une électronique destinée à collecter les signaux émis par les détecteurs, cette électronique 8 est également portée par un substrat. La colonne de chromatographie sera désignée "colonne" par la suite à des fins de simplicité.

La colonne 2 comporte une extrémité d'entrée 10 et une extrémité de sortie 12. Le gaz à analyser est introduit dans la colonne par l'extrémité d'entrée 10 et est évacuée par l'extrémité de sortie 12. Le module de détection 4 comporte également une extrémité d'entrée 14 et extrémité de sortie 16.

L'extrémité de sortie 12 de la colonne 2 est connectée à l'extrémité d'entrée 14 du module de détection 4 par une connexion fluidique 15.

L'extrémité d'entrée 10 de la colonne 2 est connectée à une alimentation en échantillon destinée à être analysé par le dispositif d'analyse. Cette alimentation n'est pas représentée.

L'extrémité de sortie 16 du module de détection 4 est reliée à des moyens de récupération de l'échantillon après son analyse ou celle-ci débouche directement dans l'environnement extérieur, par exemple dans le cas de l'analyse de l'air ambiant.

Des connexions électriques 18 sont réalisées entre les détecteurs du module de détection 4 et l'électronique 8.

Les moyens de chauffage et de refroidissement 6 sont formés par au moins un module thermoélectrique comportant une première face 20 et une deuxième face 22 sensiblement parallèles. La première face 20 forme la surface chaude du module thermoélectrique et la deuxième face 22 forme la surface froide du module thermoélectrique.

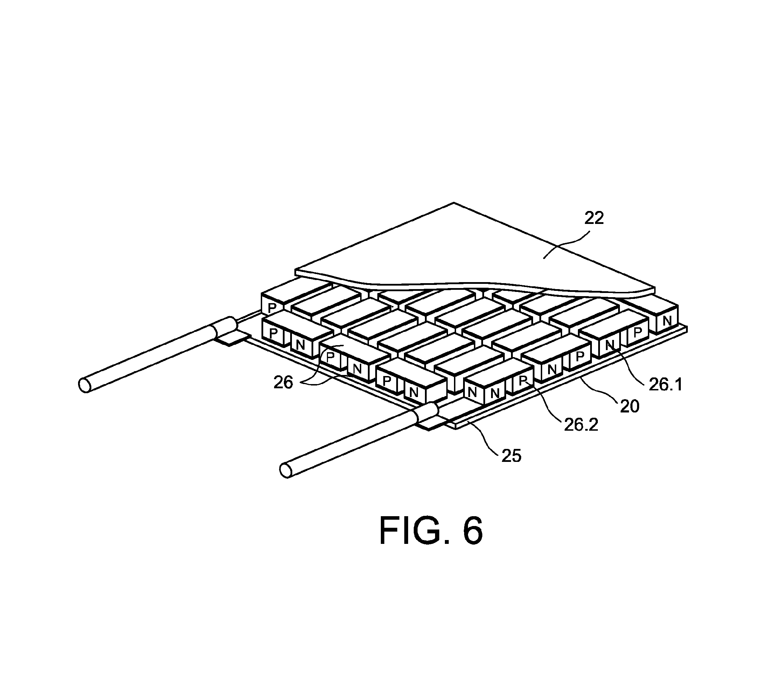

Sur la figure 6, on peut voir une vue en arraché d'un exemple de réalisation d'un module thermoélectrique apte à être mis en oeuvre dans le dispositif de la figure 1.

Le module thermoélectrique représenté sur la figure 6 comporte un substrat 25 et une pluralité de jonctions p-n 26 connectées en série. Les jonctions p-n sont formées par un matériau semi-conducteur dopé n 26.1 et un matériau semi-conducteur dopé p 26.2, les matériaux 26.1, 26.2 sont disposés de manière alternée et s'étendent entre la première surface 22 et la deuxième surface 24 du module thermoélectrique 6. Des interconnexions sont prévues entre les matériaux 26.1 dopés n et les matériaux dopés p 26.2 adjacents de sorte à former des jonctions p-n. Lorsqu'une différence de potentiels est appliquée aux jonctions p-n, elle provoque l'apparition d'un flux thermique au sein du module thermoélectrique et donc l'apparition d'une différence de température entre la face 22 et la face 24. Pour la suite, nous considérons que la face 24 est la face présentant la température la plus basse, désignée face froide et la face 22 comme celle présentant la température la plus élevée et désignée face chaude.

La colonne 2 est en contact avec la face chaude 20 et le module de détection 4 est en contact avec la face froide 22.

Le dispositif comporte de préférence des moyens 24 pour isoler thermiquement la colonne 2, le module de détection 4 et les moyens de chauffage et de refroidissements 6 par rapport à l'environnement extérieur. Par exemple, on dispose d'éléments isolants thermiques autour des connexions entre l'extrémité de sortie 12 de la colonne 2 et l'extrémité d'entrée 14 du module de détection 4 et au niveau de l'extrémité d'entrée 10 de la colonne 2 et de l'extrémité de sortie 16 et du module de détection 4.

L'ensemble du dispositif est de préférence contenu dans un boitier facilitant sa manipulation et le protégeant.

Les matériaux isolants thermiques ont également pour effet d'isoler thermiquement la face chaude de la face froide.

De préférence, la paroi interne de la colonne 4 est fonctionnalisée chimiquement, elle est recouverte d'une couche de matériau appelée phase stationnaire, par exemple du PDMS (polydimethylsiloxane).

Les détecteurs du module de détection 4 sont également avantageusement fonctionnalisés chimiquement.

De manière avantageuse, le dispositif peut être muni d'un pré-concentrateur disposé en amont de l'extrémité d'entrée 10 de la colonne 2.

De manière avantageuse, les moyens de chauffage et de refroidissement comportent des capteurs de température pour permettre le contrôle des températures de chauffage et de refroidissement, par exemple il s'agit de sondes platine ou de thermocouples.

Le dispositif d'analyse peut également comporter de manière avantageuse des capteurs de débit et/ou des capteurs d'hygrométrie disposés soit à l'intérieur de la colonne et/ou du module de détection, soit dans les connexions fluidiques du dispositif d'analyse. Ces capteurs sont connectés électriquement à l'électronique 8 de sorte que leurs signaux soient traités.

Les connexions fluidiques sont par exemple réalisées au moyen de tubes capillaires, par exemple de tubes capillaires en silice.

Les connexions électriques entre le module de détection, les différents capteurs et l'électronique sont par exemple réalisées par « wire bonding » qui est un procédé bien connu de l'homme du métier en microélectronique et qui ne sera pas décrit en détail.

En variante, on pourrait envisager de réaliser ces connexions électriques par un procédé dit « flip hip » qui consiste à utiliser des billes conductrices directement placées entre le substrat sur lequel sont formés les détecteurs et le substrat électronique. Ce procédé est également bien connu de l'homme du métier ne sera pas décrit en détail dans la présente demande. Nous allons maintenant décrire le fonctionnement du dispositif d'analyse de la figure 1.

Le dispositif est connecté à une alimentation en échantillon à analyser, cet échantillon est injecté dans la colonne 2 par l'extrémité d'entrée 10. Préalablement les moyens de chauffage et de refroidissement 6 ont été activés de sorte qu'un flux de chaleur apparaisse au travers du module thermoélectrique. Il en résulte un échauffement de la colonne 2 qui est en contact avec la face chaude 22 du module thermoélectrique et un refroidissement du module de détection 4 qui est en contact avec la face froide 24 du module thermoélectrique.

L'échantillon circule donc dans la colonne 2, la phase stationnaire provoque une séparation des différents composants de l'échantillon gazeux, ces composants séparés au sein de la colonne pénètrent ensuite dans le module de détection dans lequel ils sont détectés par le ou les différents détecteurs, les signaux émis par ces détecteurs sont traités par l'électronique, qui génère par exemple un graphique comportant une série de pics séparés dans le temps dont la taille est indicative de la concentration de chacun des éléments composant l'échantillon gazeux. C'est le temps séparant l'injection de l'échantillon gazeux de l'apparition du pic qui permet d'identifier la nature du gaz après étalonnage.

Grâce au chauffage de la colonne 2, la séparation spatiale des espèces est améliorée, et grâce au refroidissement des détecteurs du module de détection 4 l'effet de piégeage des composés gazeux par physisorption est amélioré. Ce piégeage est favorisé lorsque la température est inférieure à la température ambiante de 10°C à 20°C.

A titre d'exemple la colonne est échauffée à une température de l'ordre de 70°C C et le module de détection est refroidi à une température de 5°C.

Grâce à l'invention, le dispositif d'analyse présente une grande compacité puisqu'il utilise le même élément pour chauffer la colonne et pour refroidir les détecteurs. Il en résulte également une diminution à la consommation d'énergie électrique nécessaire au chauffage et au refroidissement puisque le chauffage et le refroidissement sont obtenus simultanément par une seule alimentation de l'élément thermoélectrique. En effet, toute la chaleur dissipée par le module thermoélectrique est intégralement utilisée pour réchauffer la colonne. Ceci est d'autant plus efficace que le dispositif est isolé du milieu extérieur pour limiter les déperditions thermiques.

La grande compacité du dispositif présente en outre l'avantage de réduire longueur et le nombre des liaisons fluidiques, ce qui a pour effet de réduire les pertes de charge, les volumes morts, et permet également d'améliorer le contrôle de la température.

Dans la figure 2, on peut voir un autre exemple du premier mode de réalisation du dispositif d'analyse, celui-ci comportant plusieurs colonnes de chromatographie et plusieurs modules de détection.

Dans cet exemple de réalisation, le dispositif comporte trois colonnes de chromatographie superposées et trois modules de détection superposés et connectés fluidiquement en série. Les trois colonnes de chromatographie : 2.1, 2.2, 2.3, sont superposées de sorte que la colonne 2.1 soit en contact direct avec la face chaude 22 du module thermoélectrique 6, que la deuxième colonne 2.2 soit en contact direct avec la face de la première colonne 2.1 opposée à celle en contact avec la face chaude 20 et que la troisième colonne 2.3 soit en contact avec l'autre face de la deuxième colonne 2.2. Les trois modules de détection 4.1, 4.2, 4.3 sont reliés électriquement à l'électronique.

Les trois modules de détection 4.1, 4.2 et 4.3 sont superposés de manière similaire, seul le module de détection 4.1 est en contact direct avec la face froide 24 du module thermoélectrique 6. Par ailleurs, la première colonne 2.1 est connectée en série directement avec le premier module de détection 4.1 qui est connecté au niveau de sa sortie avec l'entrée de la deuxième colonne 2.2, elle-même connectée au niveau de sa sortie avec l'entrée du deuxième module de détection 4.2, qui est connecté en sortie à l'entrée de la troisième colonne 2.3 connectée en sortie à l'entrée du troisième module de détection 4.3 dont la sortie est connectée à un système de récupération de l'échantillon gazeux. Ainsi l'échantillon gazeux lorsqu'il est injecté en entrée de la première colonne 2.1 circule successivement dans la colonne 2.1, dans le module de détection 4.1, dans la colonne 2.2, dans le module de détection 4.2, dans la colonne 2.3, et enfin dans le module de détection 4.3 avant d'être évacué.

Dans cette réalisation, le chauffage des deuxième et troisième colonnes fait par conduction à travers la première colonne 2.1 en contact direct avec la face chaude 20 et le refroidissement des détecteurs 4.2 et 4.3 se fait par conduction à travers le module de détection 4.1 en contact direct avec la face froide 22.

Il sera compris que les colonnes de chromatographie 2.1, 2.2, 2.3 peuvent présenter des longueurs et des diamètres différents les unes des autres ainsi qu'une fonctionnalisation chimique différente, c'est-à-dire une phase stationnaire différente et les modules de détection peuvent être identiques ou différents, être réalisés dans des matériaux, des géométries différentes, et présenter également des fonctionnalisations chimiques différentes.

Cette réalisation est particulièrement intéressante dans le cas de la présente invention du fait de la grande compacité et de la longueur réduite des connexions fluidiques obtenues grâce à la mise en oeuvre d'un élément thermoélectrique. Les pertes de charge et les volumes morts sont réduits et le contrôle de la température est amélioré.

Le dispositif d'analyse de la figure 2 offre une résolution améliorée, puisque chaque module de détection est dédié à l'analyse d'une catégorie de composés.

Au vu de la taille très réduite de l'ensemble, il est supposé qu'il n'y a pas de différence de température notable entre la colonne disposée directement en contact avec la face chaude et les autres colonnes et entre l'ensemble des détecteurs directement en contact avec la face froide, et les autres ensembles détecteurs. En outre, Les matériaux des colonnes et/ou des modules de détections peuvent être choisis bons conducteurs thermiques, l'ensemble de l'empilement est alors sensiblement à la même température.

En variante, on pourrait souhaiter obtenir un gradient de température, pour cela il est envisageable d'intercaler des matériaux isolants entre les colonnes, et entre les ensemble de détecteurs.

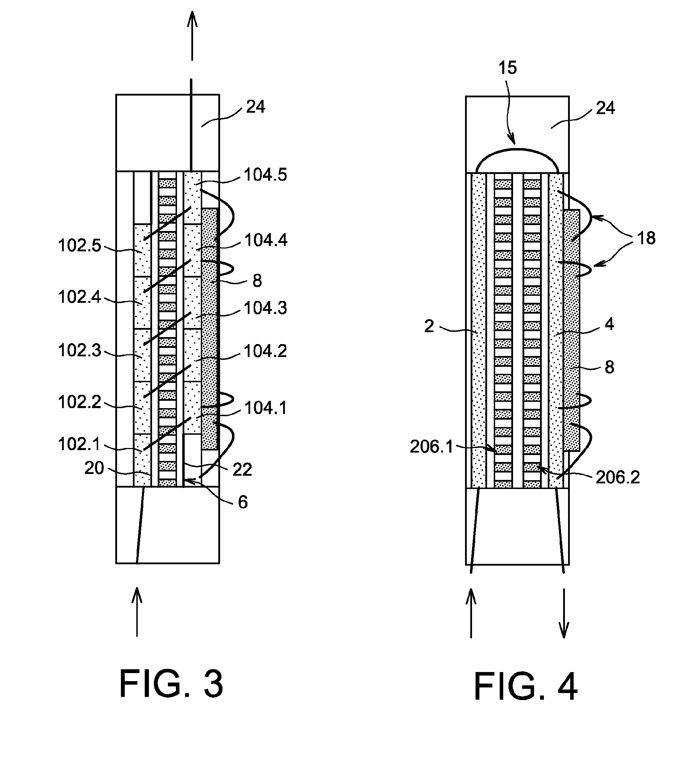

Sur la figure 3, on peut voir un autre exemple du premier mode de réalisation.

Le dispositif de la figure 3 comporte également plusieurs colonnes et plusieurs modules de détection. Ce dispositif diffère de celui de la figure 2 en ce que toutes les colonnes sont en contact direct avec la face chaude 22 du module thermoélectrique 6, et tous les modules de détection sont en contact direct avec la face froide 24 du module thermoélectrique 6.

Dans l'exemple représenté, le dispositif comporte cinq colonnes : 102.1 à 102.5 et cinq modules de détection 104.1 à 104.5. La première colonne 102.1 est alimentée par un dispositif d'alimentation en échantillon analysé et est connectée en série à un premier module de détection 104.1 par l'intermédiaire d'une connexion fluidique qui chevauche le module thermoélectrique latéralement, ensuite le premier module de détection 104.1 est connecté en sortie à l'entrée de la deuxième colonne 102.2 par une connexion fluidique chevauchant latéralement le module thermoélectrique 4 (cette connexion n'est pas visible sur la représentation de la figure 3). Les colonnes et les modules de détection sont connectés de manière similaire et le cinquième module de détection 104.5 est connecté en sortie au dispositif de récupération de l'échantillon.

Ce dispositif présente l'avantage que toutes les colonnes soient en contact directement avec la surface chaude et voient donc la même température et que tous modules de détection soient en contact direct avec la face froide et voient donc la même température.

Comme pour l'exemple de la figure 2, ce dispositif d'analyse présente une sensibilité améliorée puisque chaque module de détection est dédié à la détection d'une catégorie de composés. Et comme pour le dispositif de la figure 2, les colonnes ne sont pas nécessairement identiques en structure et en fonctionnalisation chimique ainsi que les modules de détection.

Le fonctionnement du dispositif de la figure 3 est similaire à celui du dispositif de la figure 2.

Sur la figure 4, on peut voir un exemple d'un deuxième mode de réalisation d'un dispositif d'analyse selon la présente invention dans lequel deux éléments thermoélectriques sont mis en oeuvre.

Dans ce mode de réalisation, les moyens de chauffage et de refroidissement comportent deux éléments thermoélectriques 206.1 et 206.2. La face chaude du module thermoélectrique 206.1 est en contact avec au moins une colonne 4 et la face froide du module thermoélectrique 206.2 est en contact direct avec au moins un module de détection. La face froide du module thermoélectrique 206.1 est en contact direct avec la face chaude du module thermoélectrique 206.2. Ces moyens de chauffage et de refroidissement permettent d'augmenter l'écart de température entre la surface froide et la surface chaude des moyens de refroidissement et de chauffage. Par exemple, pour l'écart de température peut être augmenté de 65°C à 95°C, la surface froide étant à - 5°C et la surface chaude à 90°C.

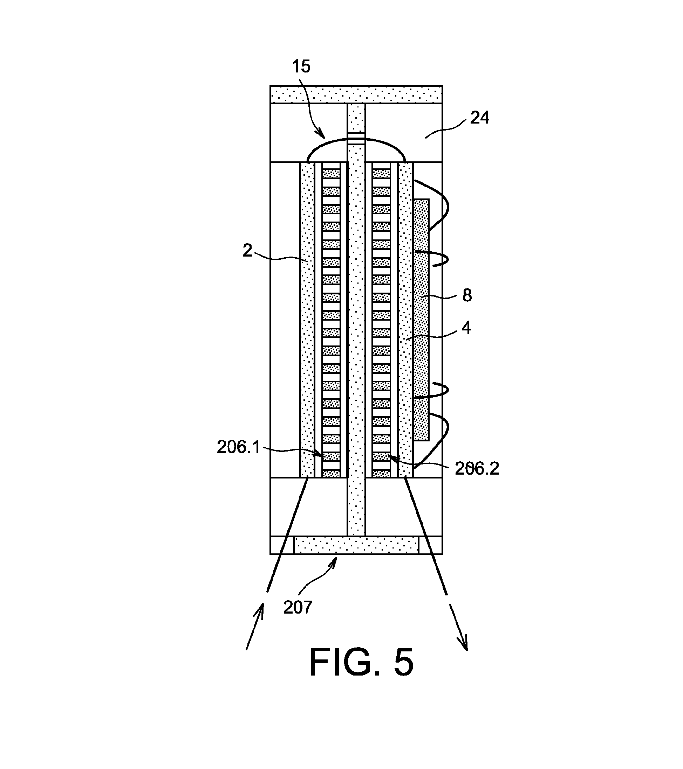

Sur la figure 5, on peut voir un autre exemple du deuxième mode de réalisation dans lequel les moyens de chauffage et de refroidissement comportent deux éléments thermoélectriques. Ces moyens diffèrent de ceux mis en oeuvre dans le dispositif de la figure 4 en ce que des moyens de dissipation de la chaleur 207 sont interposés entre les deux éléments thermoélectriques. Les moyens de dissipation de la chaleur sont par exemple formés par un radiateur en matériau offrant une bonne conduction thermique dont une face est en contact direct avec la surface chaude du module thermoélectrique 206.2 et une autre face est en contact direct avec la surface froide du module thermoélectrique 206.1. Les moyens de dissipation sont par exemple en cuivre ou en aluminium.

Ces moyens de chauffage et de refroidissement permettent de régler séparément les températures chaude et froide et ceci indépendamment de la température ambiante. Leur fonctionnement est similaire à celui décrit en relation avec le dispositif de la figure 1.

Les moyens de chauffage et de refroidissement mis en oeuvre dans les dispositifs des figures 4 et 5 peuvent être mis en oeuvre dans les dispositifs des figures 2 et 3, c'est-à-dire dans des dispositifs comportant plusieurs colonnes et plusieurs ensembles détecteurs.

Par ailleurs, on peut envisager de combiner les structures des dispositifs des figures 2 et 3. Par exemple, le dispositif d'analyse pourrait comporter des colonnes superposées et des ensembles détecteurs juxtaposés ou inversement.

En outre, en particulier, dans le dispositif de la figure 4, on peut envisager de mettre en oeuvre plus de deux éléments thermoélectriques si l'on souhaite encore accentuer la différence de température entre la température froide et la température chaude.

A titre d'exemple, la matrice de détecteurs peut présenter des dimensions comprises entre 2 x 2 mm et 10 x 20 mm.

La colonne peut présenter les dimensions comprises entre 10 x 10 mm et 30 x 30 mm.

Le dispositif peut être fabriqué entièrement pas des techniques de la microélectronique.

A titre d'exemple, les différents éléments du dispositif sont réalisés indépendamment et assemblés par une colle telle que de l'époxy conductrice thermiquement ou par assemblage mécanique notamment avec des brides de serrage. Dans ce dernier cas, pour améliorer la conduction thermique entre les différents éléments, on peut ajouter une graisse thermique ou un joint thermique.

Le dispositif de détection selon la présente invention offre une grande compacité et une grande performance de détection. Il est particulièrement adapté à une utilisation nomade.

Le dispositif de détection peut par exemple être utilisé dans le domaine médical, dans les laboratoires, dans des dispositifs de sécurité, et dans des domaines liés à l'environnement.

## Revendications

1. Dispositif d'analyse par chromatographie en phase gazeuse comportant :
- au moins une micro-colonne de chromatographie (2),
- au moins un module de détection (4) comportant au moins un détecteur de type NEMS et/ou MEMS disposé dans un canal,
- une connexion fluidique directe entre une extrémité d'évacuation de la micro-colonne de chromatographie (2) et une extrémité d'admission du canal du module de détection (4),
ladite micro-colonne de chromatographie et ledit détecteur formant un sous-ensemble d'analyse,
- des moyens de chauffage de la micro-colonne de chromatographie (2) formés par une face chaude d'au moins un module thermoélectrique (6),
- des moyens pour refroidir le module de détection,
dans lequel les moyens pour refroidir le module de détection (4) sont formés par la face froide du module thermoélectrique (6).

2. Dispositif d'analyse selon la revendication 1, comportant au moins un premier (206.1) et un deuxième (206.2) module thermoélectrique.

3. Dispositif d'analyse par chromatographie en phase gazeuse comportant :
- au moins une micro-colonne de chromatographie (2),
- au moins un module de détection (4) comportant au moins un détecteur de type NEMS et/ou MEMS disposé dans un canal,
- une connexion fluidique directe entre une extrémité d'évacuation de la micro-colonne de chromatographie (2) et une extrémité d'admission du canal du module de détection (4),
ladite micro-colonne de chromatographie et ledit détecteur formant un sous-ensemble d'analyse,
- des moyens de chauffage de la micro-colonne de chromatographie (2) formés par une face chaude d'au moins un premier module thermoélectrique (206.1),
- des moyens pour refroidir le module de détection,
dans lequel les moyens pour refroidir le module de détection (4) sont formés par la face froide d'un deuxième module thermoélectrique (206.2),
et dans lequel une face froide du premier module thermoélectrique (206.1) est en contact thermique avec une face chaude du deuxième module thermoélectrique (206.2).

4. Dispositif d'analyse selon la revendication 3, dans lequel la face froide du premier module thermoélectrique (206.1) est en contact direct avec la face chaude du deuxième module thermoélectrique (206.2).

5. Dispositif d'analyse selon la revendication 3, dans lequel une face froide du premier module est en contact avec un dissipateur thermique (207), une face chaude du deuxième module thermoélectrique (206.2) est en contact avec ledit dissipateur thermique et une face froide du deuxième module thermoélectrique (206.2) forme les moyens de refroidissement.

6. Dispositif d'analyse selon l'une des revendications 1 à 5, comportant au moins deux sous-ensembles d'analyse connectés en série.

7. Dispositif d'analyse selon la revendication 6, dans lequel les micro-colonnes de chromatographie étant superposées de sorte qu'une seule des micro-colonnes de chromatographie soit en contact avec les moyens de chauffage.

8. Dispositif d'analyse selon la revendication 6 ou 7, dans lequel les modules de détection sont superposés de sorte qu'un seul module de détection soit en contact avec les moyens de refroidissement.

9. Dispositif d'analyse selon la revendication 6, dans lequel les micro-colonnes de chromatographie étant juxtaposées de sorte que toutes les micro-colonnes de chromatographie soient en contact avec les moyens de chauffage.

10. Dispositif d'analyse selon la revendication 6 ou 9, dans lequel les modules de détection sont juxtaposés de sorte que tous les modules de détection soient en contact avec les moyens de refroidissement.

11. Dispositif d'analyse selon l'une des revendications 6 à 10, dans lequel chaque sous-ensemble est fonctionnalisé pour détecter un ou plusieurs analytes donnés.

12. Dispositif d'analyse selon l'une des revendications 1 à 11, comportant des moyens d'isolation thermique au moins autour du module ou de l'ensemble des modules.

13. Dispositif d'analyse selon l'une des revendications 1 à 12, dans lequel la au moins une connexion fluidique est un capillaire.

14. Dispositif d'analyse selon l'une des revendications 1 à 13, comportant au moins un capteur de température et/ou un capteur d'hygrométrie et/ou un capteur de débit.
